Europäisches Patentamt

(19) European Patent Office

Office européen des brevets

(11) Publication number: **0 161 246**
**B1**

(12) **EUROPEAN PATENT SPECIFICATION**

(45) Date of publication of patent specification: **31.01.90**

(51) Int. Cl.⁵: **H 01 L 25/04, H 01 L 31/18**

(21) Application number: **83903872.6**

(22) Date of filing: **07.11.83**

(86) International application number:
**PCT/US83/01750**

(87) International publication number:
**WO 85/02283 23.05.85 Gazette 85/12**

(54) **DETECTOR ARRAY MODULE-STRUCTURE AND FABRICATION.**

(43) Date of publication of application:
**21.11.85 Bulletin 85/47**

(45) Publication of the grant of the patent:
**31.01.90 Bulletin 90/05**

(84) Designated Contracting States:
**CH DE FR GB LI NL SE**

(56) References cited:
**DE-A-2 611 828**
**US-A-3 206 832**
**US-A-3 748 479**
**US-A-3 970 990**
**US-A-4 029 962**
**US-A-4 196 508**
**US-A-4 290 844**
**US-A-4 304 624**

(73) Proprietor: **IRVINE SENSORS CORPORATION**
**3001 Redhill Avenue, Bldg. 3**
**Costa Mesa, CA 92626 (US)**

(72) Inventor: **CARSON, John, C.**
**2921 Setting Sun Drive**
**Corona del Mar, CA 92625 (US)**
Inventor: **CLARK, Stewart, A.**
**2 Rainstar**
**Irvine, CA 92714 (US)**

(74) Representative: **Arthur, John William et al**
**FITZPATRICKS 4 West Regent Street**
**Glasgow G2 1RS Scotland (GB)**

## Description

Background of the Invention:

This invention relates to the field of electro-optical detecting apparatus which utilizes "mosaic" detector arrays to provide surveillance of an extensive scene. The mosaic detector arrays are large numbers of closely spaced individual photo-detector elements arranged in essentially a two-dimensional, or planar, array.

US—A—4,304,624 discloses a detector module comprising a number of thin insulating (ceramic) layers, or substrates, secured together and extending at right angles to the focal plane of the detector array. Electrically conducting leads are supported by and located between such layers for the purpose of conducting signals away from the detectors located in the focal plane. The prefabricated layered supporting structure thus constitutes the substrate for the detector array, which is located on one end (the focal plane) of the layered supporting structure. The individual detector elements located on the focal plane are each in separate electrical contact with one of the leads appearing at the adjacent edges of the layers which constitute the supporting structure.

A large number of the separately fabricated layered structures, or modules, are butted together to form an extensive focal plane array, i.e., the individual modules are used as building blocks to build up a complete focal plane array. The completed assembled array should be as light and as small as possible, in order to facilitate its use in such fields as satellite surveillance. At the same time, it is necessary to accomplish very significant amounts of electronic processing within the focal plane array, which means that each module, or layered structure, in the array must incorporate in its "body portion" a substantial amount of electronic processing capability. Otherwise, it would not be feasible to provide electrical connections between the detector array and the processing equipment remote from the focal plane.

As pointed out in US—A—4,304,624, in order that the detector-carrying modules may be butted against one another to provide a continuous surveillance array, it is necessary that any electronics contained within the modules be housed in the "volume" of space created by extending the two-dimensional surface area of the focal plane detector array in a direction perpendicular to that two-dimensional surface. Nothing must protrude from the "sides" of the individual modules; and their electrical connections to the remotely located processing equipment should, if possible, be formed by leads on the back planes of the modules.

Some of the primary considerations in developing improved modules for focal plane detector arrays are:

1) Optimizing packing density to achieve the lowest possible mass per element, essentially the shortest module that is production worthy;

2) Assuring end-to-end continuity of the electrical leads;

3) Simplifying the fabrication procedures;

4) Enhancing the structural strength of the elements;

5) Improving reliability of the electronics and of the techniques for interconnecting the electronics with the electrical leads;

6) Maximizing suitability for test and repair at the lowest level of assembly and throughout assembly; and

7) Minimizing the cost per element.

It is the general purpose of the present invention to make a major improvement in the apparatus and method designed to attain the listed objectives. One of the major limitations encountered with the ceramic-substrate layered modules of US—A—4,304,624 has been the inefficient use of "real estate" because the lead patterns consume most of the available space. Other advantageous aspects of the present invention over the prior design discussed above are the elimination of the multiplicity of wire bonds in the module electronics, and the utilization (in the present invention) of the rear plane of the module as a surface for printed circuitry which provides electrical connection to the remote signal processing equipment.

The prior art includes US—A—3,748,479, and its parent US—A—3,631,251. Those patents disclose the use of a stack of silicon slabs having p—n junction photocells on their narrow edges to provide a focal plane surface, and having electrical circuit elements, including transistors, formed on the larger planar surfaces of silicon material. These patents apply the concept of stacked silicon slabs to light emission, reception, or modulation. In the light-reception versions, which are of interest in connection with the present invention, the light sensors, or photo-detectors, in Lehovec are integrally formed as p—n junction photocells in the silicon material.

A major shortcoming of the light-reception structures of these prior art patents is the reliance on the treated silicon material for light sensing. This limits significantly the effective light-sensing capability of the device. The detector material does not respond adequately unless cooled to extremely low temperatures, lower than those required for other detector materials, such as may be used with structures described in this disclosure. Furthermore, the present arts in silicon detector processing and in silicon electronics processing are not fully compatible with one another, in that high performance cannot be simultaneously achieved in detectors and electronics.

As disclosed in US—A—4 290 844, effective photo-detector arrays on modules of the type under discussion require the use of specialized detector materials, such as mercury-cadmium telluride, indium antimonide, lead tin telluride, indium arsenic antimonide, indium arsenide, and indium gallium arsenide. And such detector materials necessitate a "hybrid" technology for securing the detectors to the focal plane provided by the narrow ends of the stacked substrates.

The present invention is intended to solve the problems which must be overcome in order to combine the benefits of the "hybrid" detector concepts with the use of stacked silicon chips which carry integrated electronic circuits, and which are efficiently connected to external circuitry.

Summary of the Invention:

The present invention provides a photodetector array module and a method of fabricating the same, as defined in the claims.

Brief Description of the Drawings:

Figure 1 is a view in perspective of a module comprising a number of stacked silicon chips, each of which provides an integrated circuit terminating in a multiplicity of electrical leads at the front end (focal plane) of the module, and a plurality of electrical leads at the rear end (lead-out plane) of the module;

Figure 2 is an exploded view of the detector module shown in Figure 1;

Figure 3 is a partially exploded view in perspective showing a combination of four of the modules of Figure 1 in a larger module which can be handled as a unit in assembling a focal plane array;

Figure 4 is a view in perspective of a complete focal plane assembly (except for portions omitted to improve clarity), having a large number of the four-module units of Figure 3 supported on a cold plate mounting structure;

Figure 5 is a diagrammatic showing of the electronic system, which indicates those portions which are located remotely from the focal plane;

Figures 6A through 6D are cross-sectional closeups of several layers of silicon chips, illustrating the step-by-step processing used to insulate the front and back surfaces of the modules in such a way as to provide individually exposed multiple electrical leads on each surface;

Figures 7A and 7B are greatly magnified sectional closeups showing an individual electrical lead on the focal plane contacting the conductive epoxy which secures a single photo-detector in position;

Figure 8 is a cross-sectional closeup showing detectors mounted on the focal plane of the module and in individual electrical contact with separate electrical leads on the focal plane edges of the silicon chip layers;

Figure 9 is a cross-sectional view through a module illustrating the thin film electrical conductors which connect the leads on the rear of the silicon layer stack with the signal cable leading away from the focal plane assembly;

Figure 10 is an exploded view in perspective illustrating the steps required to make the electrical connections shown in Figure 9;

Figures 11A through 11N are illustrations, generally in perspective, which outline the steps taken in building a stack of silicon chips to form a module;

Figures 12A through 12E are illustrations which summarize the steps taken in providing electrical contacts on the focal plane and back plane of the module.

Figures 13A through 13J are illustrations showing the steps taken to assemble the remaining parts of the module, and to complete the electrical connections at the back of the module; and

Figures 14A through 14D briefly summarize the application of photo-detectors to the focal plane thereby completing the module.

Detailed Description of Preferred Embodiments:

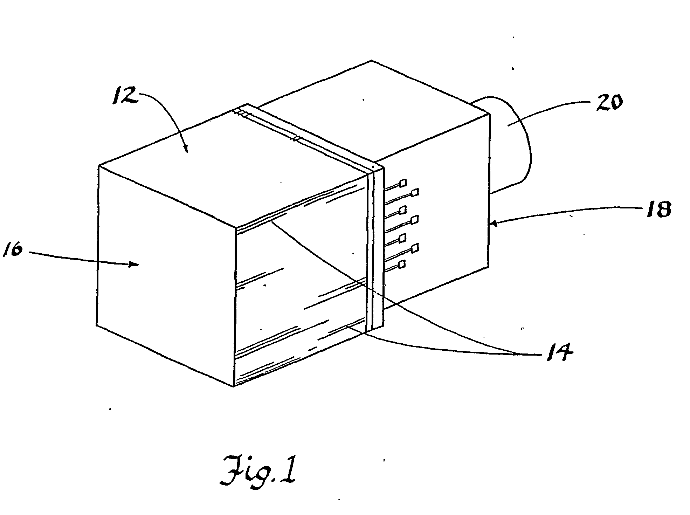

Figure 1 shows a module 12 comprising a multiplicity of layers 14, each of which is a semiconductor chip (preferably silicon) which carries an integrated circuit having suitable electrical leads terminating at a front, or focal, plane 16, where they are individually in electrical contact with separate very closely spaced photodetectors. The module 12 is in effect, a stack, or "sandwich", comprising numerous silicon chips, or substrates, secured together by suitable adhesive material between adjacent chips. The module, or stack, may be described as a rectangular parallelepiped, since each of its surfaces is a rectangle. The stack of chips is mounted on a supporting block 18, which also functions as a heat-transfer, or cooling, structure, and which may have a mounting stud 20 for use in securing the module and its supporting block in a larger assembly. Generally, the combination of the stack of silicon chips and the supporting block is considered to be a module assembly.

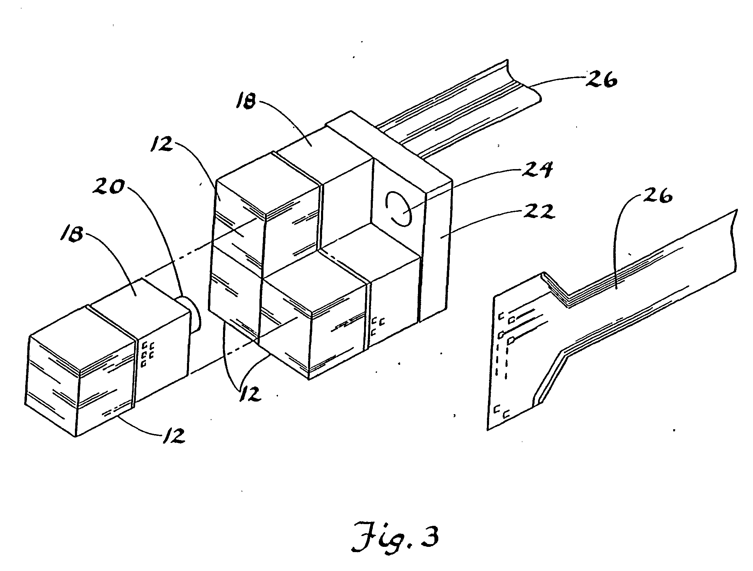

Figure 3 shows a larger module, consisting of four of the modules 12 of Figure 1 mounted on a single mounting plate 22, with each mounting stud 20 fitting into a hole 24 provided in mounting plate 22. Ribbon cables 26 provide electrical connections leading from the modules 12 to suitable electronic information processing equipment. The arrangement of the four-module assembly is such that each ribbon cable 26 provides electrical connections for two of the modules 12.

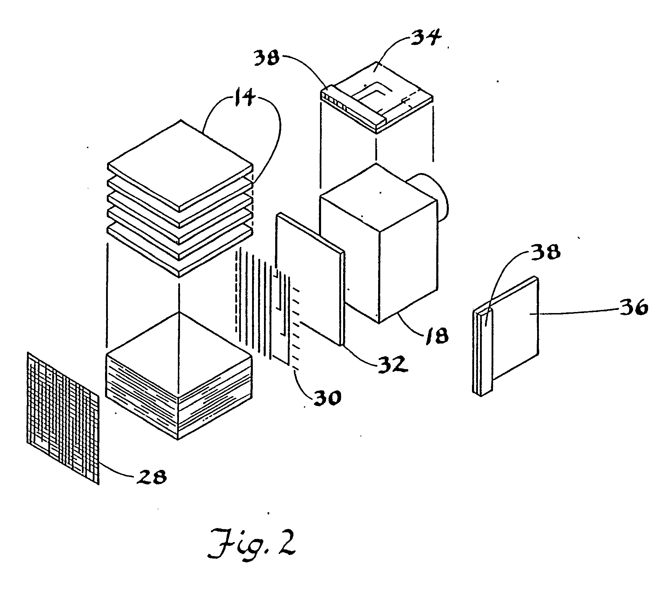

Referring now to Figure 2, which is an exploded view of a module 12, it is seen that it includes separately formed silicon chips 14 which, after being stacked and glued together, are provided on the front, or focal, plane with a detector "mosaic" 28 and on the rear, or back, plane with back plane wiring 30. The supporting block 18 is preferably molybdenum, selected because of its thermal compatibility with silicon. It is insulated from the back plane of the silicon substrate stack by a flat insulating board 32, preferably formed of silicon having silicon oxide grown or deposited on its surfaces. Two additional insulating boards 34 and 36, also preferably formed of silicon, are secured to two sides of molybdenum block 18, and are arranged to carry lead-out conductors from the back plane wiring 30 to the ribbon cables 26. Each of the insulating boards 34 and 36 has an insulating strip 38 secured thereto, the purpose of which will be discussed below.

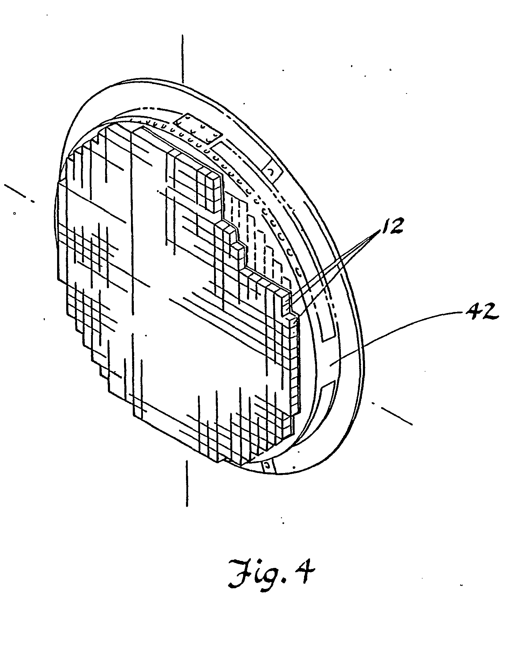

Figure 4 shows how a complete "focal plane assembly" might be constructed. A very large number of the four-module groups carried by the mounting plates 22 are secured to a relatively large cold plate mounting structure 42. It is important that the entire assembly be as thin as possible, both to provide effective cooling of the sensors and of the "focal plane" electronics, and to minimize the required volume and weight of the assembly.

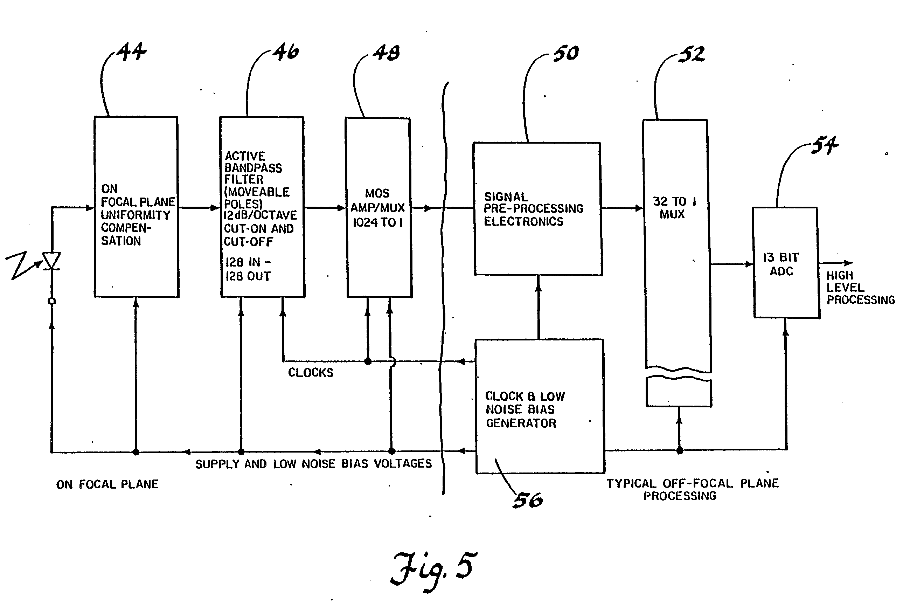

Figure 5 illustrates one version of the electronics system, as it might be divided between "on-focal plane" and "off-focal plane" electronics. The integrated circuitry on each silicon chip should carry the maximum amount of electronics permitted by the available "real estate", in order to simplify connections from the focal plane assembly to the other portions of the electronic system. It should also provide large dynamic range with low noise and power dissipation, and should operate at temperatures as low as 30 degrees centigrade above absolute zero. In Figure 5, three blocks in the diagram are shown on the stacked chips, and four blocks are shown as part of the off-focal plane electronics. Block 44, which is Non-Uniformity Gain Compensation circuitry on the chips, represents automatic gain compensation circuitry, which uses a signal developed by the detector when it is periodically flooded with a calibration signal, and automatically compensates for non-uniformity in individual detector gain or responsivity characteristics due to temperature gradients, background radiation, etc. Block 46, which is Active Adaptive Bandpass Filter circuitry on the chips, represents adaptive bandpass filter circuitry, comprising capacitors and capacitor/electronic switch circuits to emulate resistors. And block 48, which is Multiplexer circuitry on the chips, represents MOS amplifier/ multiplexer circuitry, which in the disclosed version of the system provides 1024 to 1 multiplexing leading to the remotely located electronics. The latter may include signal preprocessing electronics 50, leading to a 32 to 1 multiplexer 52, which provides signals to a 13 bit analog-to-digital converter 54, leading to high level signal processing electronics. Also included in the off-focal plane electronics is a clock and bias generator 56, which supplies biasing voltage to the detectors on the face of the modules, to the adaptive bandpass filter circuitry 46, and to the multiplexer circuitry 48; and also supplies timing signals to the adaptive bandpass filter circuitry 46, and to the multiplexer circuitry 48.

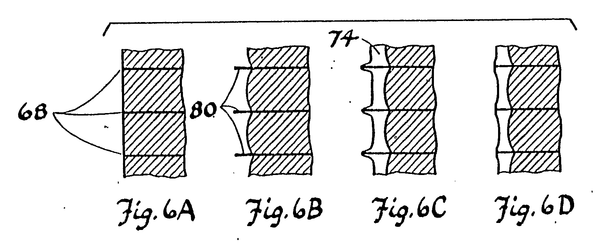

Figure 6 illustrates a high significant aspect of the processing which makes it possible to build the stacked silicon modules successfully. This process has been used effectively both on the front, or focal, plane and on the back plane of the modules, for the purpose of providing an insuating surface which does not cover the ends of the electrical leads, but otherwise fully covers the end surfaces of the stacked silicon chips. Since the silicon substrate is a doped semiconductor, any failure to insulate any of its exposed surfaces will lead to short circuits.

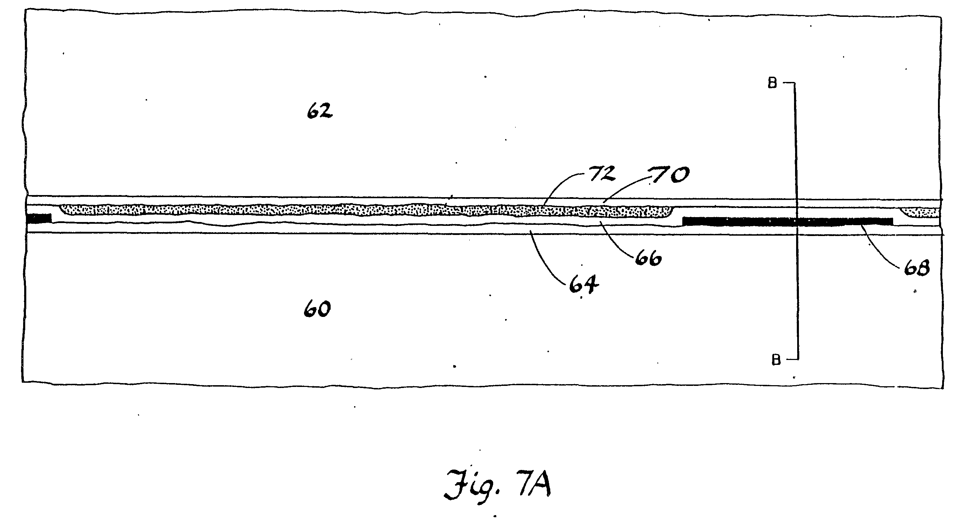

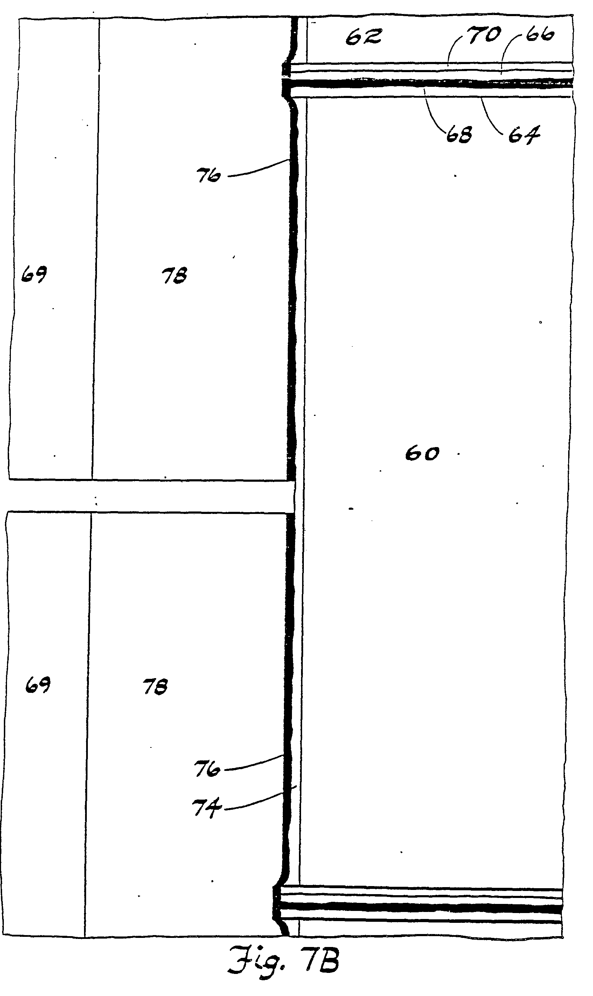

Before explaining the unique process, the steps of which are illustrated in Figure 6, it will be useful to understand clearly the final result which must be achieved in connecting the electrical leads on the focal plane individually to separate detectors. Figures 7A and 7B are greatly magnified cross sections showing the relation of the invididual electrical leads to their separate photo-detectors. Figure 7A shows the intersection of two stacked silicon chips; and Figure 7B is a cross section on the line B—B of Figure 7A showing the relation of the end of a silicon chip, and the electrical leads, to the bottom of the detectors.

In Figure 7A a lower silicon chip, or substrate, is indicated at 60, and an upper silicon chip, or substrate, is indicated at 62. The lower chip 60 has two thin layers of silicon oxide ($SiO_x$) which insulate the upper planar surface of the chip. A first layer 64 is located directly on the upper surface of the chip; a second layer 66 is provided to cover the metal leads, one of which is identified by the numeral 68. As seen in Figure 7A, the second $SiO_x$ layer 66 has undulations in its profile because it covers the leads 68. These layers of insulation are either grown on, or deposited on, the original silicon wafer by the supplier, who also provides the integral individual electrode leads 68 lying on top of the lower silicon oxide layer 64. Preferably, the upper chip 62 also has a thin layer of silicon oxide 70 which insulates the lower planar surface of chip 62. This layer of insuation is not formed on the original silicon wafer, for reasons which will become apparent in the detailed processing description, but is applied by deposition just before the chip is laminated into the module stack.

As seen in Figure 7A, an epoxy layer 72 is used to glue the chips 60 and 62 together. Forcing the chips together during the stacking process tends to displace the epoxy from the space occupied by the metal leads 68; so the epoxy is located betwen the leads as shown. A type of epoxy which has proved suitable for the gluing of the silicon chips is unfilled Epotek H77.

A fundamental problem which must be solved, and which has proved very difficult to solve, in order to successfully use stacked silicon chips, is the passivation (insulation) of the focal plane edges of the chips. This layer of passivation, which may also be formed of $SiO_x$, is identified by the numeral 74 in Figure 7B. As shown, this layer should fully cover the left edges (as oriented in Figure 7B) of the chips 60 and 62 without covering the left end of the metal conductor 68, which must be in electrical contact with the individual detector 69 through the conductive epoxy 78. If the detector emplacement process is carried out in accordance with the disclosure of US—A—4 290 844, a metallic layer 76 will be deposited on the focal plane surface on top of the passivation layer 74, after which a thicker layer of conductive epoxy 78 will be applied, as the means for securing the wafers of detector material to the focal plane. Thereafter, the detector material wafers wil be cut into isolated "islands" by a suitable material removal process, such as ion milling. Clearly, it is necessary that the metallic leads 68 have effective electrical contact with the metal layer 76, in order to receive signals from the respective detector islands.

Two available but unsatisfactory prior art methods for attempting to insulate the focal plane ends of the stacked chips completey, except for the ends of the leads, are: (a) thermal growth of native silicon oxide selectively on the silicon, and (b) photolithographic methods of selectively etching holes through a deposited insulating coating to expose the ends of the leads. Selective growth of the native oxide is not possible because high temperatures and/or high voltages would degrade other materials in the completed structure, such as the adhesive, lead metallization, and low level circuits. Photolithographic techniques are not feasible because the accuracies of the dimensions between adjacent rows of the leads are determined in part by wafer lapping accuracy. The very small pad overlap at the lead end permitted by the thin passivation layers 64, 66 and 70 applied to the original silicon wafers requires lead placement tolerances smaller than can be obtained by lapping and stack fabrication techniques.

The unique method developed to cover the focal plane ends of the stacked chips completely with an insulation layer, except for the ends of the leads 68, is best understood with reference to Figures 6A to 6D. In Figure 6A, a stack of silicon chips (part of a module) is shown in cross section, with metallic leads 68 therebetween (insulation between layers is not shown). The left end of the module should be lapped, in order to provide a smooth focal plane surface and ensure that the leads 68 are exposed.

The next step is to etch the edges of the silicon chips. In Figure 6B, the left (focal plane) edges of the chips have been etched to remove the silicon to a depth of about .0005 inch (0.0127 mm) causing the etch-resistant ends 80 of the lead 68 to protrude, as shown. After that, as shown in Figure 6C, the passivation layer 74 is deposited on the focal plane ends of the stacked chips. And finally, as illustrated in Figure 6D, the left end of the stacked chip module is lapped, preferably with a relatively soft lapping compound, in order to uncover the tips of leads 68 without removing the passivation layer 74 from the edges of the silicon chips.

The effective performance of the method illustrated in Figures 6A to 6D has proved to be very difficult to accomplish, primarily because of the necessity that the ends 80 of the leads 68 protrude as straight as possible after removal of the silicon material. If the ends of the leads bend, they will "shadow" the adjoining silicon area during passivation, thereby tending to cause a short circuit to the silicon from metallization applied over the passivation.

Since the thin film metal leads are considered to be too weak to be self-supporting, it is assumed that one of the other contiguous materials, either the expoy layer or the silicon oxide layers between the chips, must be relied on to prevent collapse of the protruding leads when the silicon edges are etched. It was originally believed that the epoxy layer would usefully support the metal leads; so the etchant chosen was intended not to attack significantly either the metal or the epoxy. However, experimentation has led to the conclusion that the layers of $SiO_x$ insulating material provide the most effective support for the metal leads. Accordingly, it is important to use etching material which does not significantly attack the silicon oxide.

A surprising discovery was the apparent negative effect of the epoxy on the metal leads during the etching process. It appears that the etching material used on the silicon causes the epoxy to swell. This swelling of the epoxy results in crumbling of the protruding silicon oxide which is left unsupported as the silicon is removed. Crumbling of the silicon oxide removes support from the protruding metal leads. Accordingly, it is desirable to include an etching step in which the epoxy edges are etched away before the etching step which acts on the silicon.

The epoxy etching may be accomplished effectively using hot sodium hydroxide, i.e., by applying a 25 percent solution of NaOH at 90°C. The epoxy preferably is etched away to a depth of about .001 inch (0.0254 mm). Thereafter, the silicon may be etched away, preferably to slightly less depth than the epoxy, using a standard silicon etch, such as nitric acid ($HNO_3$) and hydrofluoric acid (HF) combined in a 4:1 ratio.

Providing the passivation layer, after the etching has been carried out, may be accomplished by vacuum depositing $SiO_x$. This may be done by evaporating SiO in a vacuum chamber (in which the module has been placed), while bleeding $O_2$ into the chamber. The resulting silicon oxide layer comprises both SiO and $SiO_2$. Other insulation-layer-adding possibilities have been considered and/or tried. Selection of $SiO_x$ as the passivation material is based on the covenient availability of equipment. A passivation epoxy, such as Epotek H77, has been tried, but it was not satisfactory because of a tendency to "peel away" from the silicon. Silicon nitride ($Si_3 N_4$) would be a preferable insulation material because it provides a tougher film. However, the normal processes by which a layer of silicon nitride would be formed would be either sputtering, or growing the layer on the silicon of the chips. Sputtering was not considered desirable primarily because sputtering equipment was not conveniently available. Growing the insulation material is not feasible because the electrical energy and/or heat involved in such a process might damage the circuitry on the chips. Except for this consideration, it would appear that an ideal solution to the passivation layer problem would be to anodize the silicon to form passivation on the silicon only, without covering the metal leads. Another type of passivation successfully tried was reactively sputtered aluminum oxide.

A promising procedure, which is being investigated, involves the use of a plasma processing scheme which would accomplish both the etching step and the insulation-depositing step with the same equipment. The silicon would be etched by a dry plasma etching process (isotropic) in a vacuum chamber. And the passivation step would be accomplished immediately thereafter in the same vacuum chamber by introducing, and exciting, reactant gases to cause the deposition of silicon nitride (a preferred material, as stated).

The plasma process achieves etching through the use of an excited gas plasma which eliminates the need for wet chemical etchants. The stacked chips to be etched are loaded in a planar reaction chamber and the lid is closed. Air is then pumped out of the chamber to create a vacuum. The etch gas is introduced into the chamber at a constant rate, and power is applied to ionize the gas. The gas forms chemically active radicals which react with photoresist-free substrate surfaces to accomplish the etching.

The plasma process for film deposition is a function of time, gas, pressure, power and temperature. After substrates have been loaded in a planar reaction chamber, the system is pumped down, and substrates are heated to predetermined temperatures. For silicon nitride deposition, silane and nitrogen reactant gases are introduced into the chamber. Power is applied to create a highly energetic plasma in which the nitrogen gas is dissociated. The dissociated gas interacts with silane to deposit silicon nitride film on the substrate surface.

The vacuum chamber plasma process would have the additional advantage of being a dry process, which should not cause swelling of the epoxy; and, therefore, it would eliminate the need for the separate epoxy etching step discussed above. Additional information indicates that, for the reasons first stated, this dry etching process is, in fact, the most satisfactory way of accomplishing the substrate etching, and requires only one etching step.

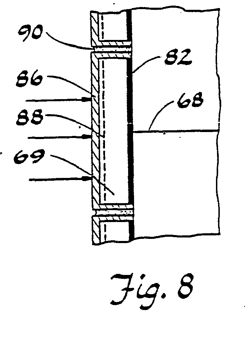

The steps required to form or place individual detectors on the focal plane of the module, in separate electrical contact with the ends 80 of the metal leads 68, are preferably performed as the final steps in preparing the modules shown in Figures 1 and 2. These final steps, which will be further discussed below, will result in a structure having a cross section similar to that shown in Figure 8, which is identical to Figure 7 of US—A—4 290 844, except that the identifying numerals have been changed. The combined layers of metal 76 and of conducting epoxy 78, which were deposited on the focal plane face of the module are indicated at 82 in Figure 8. Each individual detector 69 is in contact with a single lead 68, and is an "island" physically and electrically separated from the other detectors. Each detector 84 is covered with a layer of transparent passivation 86, and has a diode junction 88 formed therein. The spaces, or channels, which separate detectors 84 are filled with a dielectric material 90, which provides mechanical support for the individual detectors.

Another major problem encountered in providing a functional module of stacked silicon chips is the connection of back plane wiring. It is highly desirable to avoid the use of wire bonding techniques because of the real estate required and because of the processing complexities. It is also desirable to avoid using any electrical connections which require extending leads around the edges, or corners, of their supporting substrates. This is true because buildup of photo-resist on the corners, during a metallization-depositing process, is likely to cause shorting leads along the substrate edges.

Therefore, it is desired to provide metallization 30 deposited (using thin film processing) on the back plane of the stacked silicon chips, which is in effective electrical contact both with the appropriate leads on the back edges of the chips, and with the electrical leads which connect to the external (off-focal-plane) electronic circuitry.

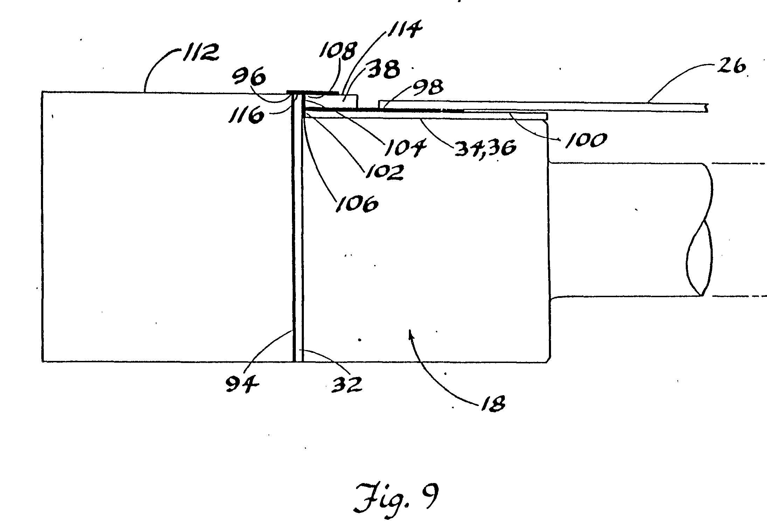

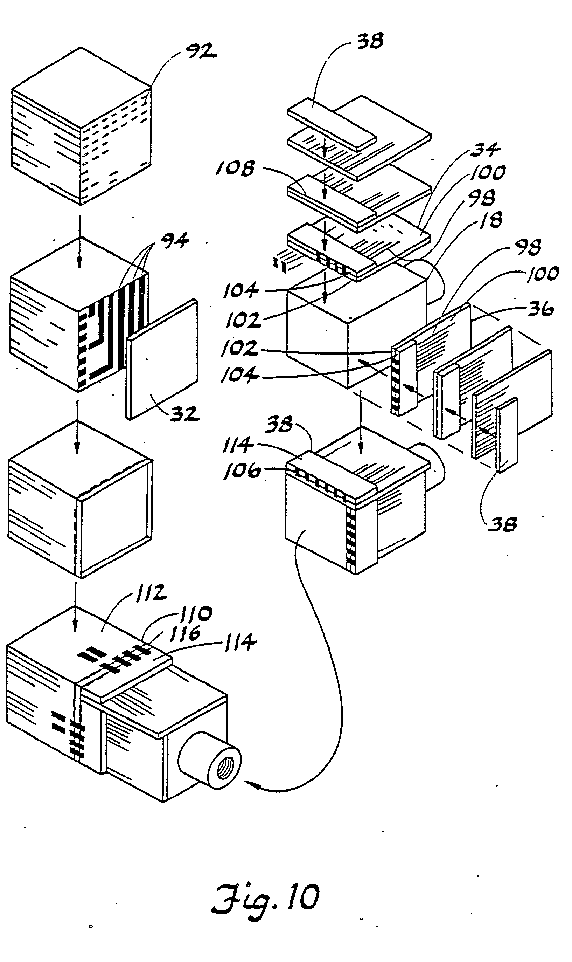

Figures 9 and 10 show the unique construction and method which have solved this problem. The electrical leads 92 which reach the back plane of the module must be effectively connected to conductors provided on the ribbon cables 26. The number of separate leads 92 which intersect the back plane of the module will obviously be much smaller than the number of detector-connected leads on the front plane of the module because of the multiplexing electronics (e.g., 1024 to 1) on each chip. However, in addition to the signals coming out from the chips, there will be back plane leads going into the chips; namely, bias voltages, clocks, and control signals.

Two concepts have provided the processing which successfully, and economically, carries the electrical leads from the back plane of the chips to the ribbon cables. The first is the process already described, and illustrated in Figures 6A—D, for passivating the edges of the chips and yet providing uncovered leads on the planar surface provided by the stacked chips. The second is a series of metallization steps which provide a series of "T-shaped" electrical joints to carry the leads around the edges of the substrates.

The first concept, as already described, provides a lapping-etching-passivating-lapping sequence which results in uncovered, accessible leads intersecting the plane on which connecting metallization is to be deposited.

The second concept, as seen in Figures 9 and 10, includes three metallizing steps which form "T-shaped" electrical junctions by depositing conductor stripes on top of the plane-intersecting ends of electrical leads. It is considered important that the metal stripes overlap the ends of the leads by at least .0005 to .001 (0.0127—0.0254 mm), thus forming a "T" which ensures good electrical contact.

The metallization 30 formed on the back plane by any suitable technique, such as photo-delineation followed by etching, includes a plurality of conductor stripes 94, each of which overlies, and is in contact with, the appropriate group of leads 92 on the back plane. The conductor stripes 94 lead to one edge 96 of the back plane.

At the other end of the lead-out connections, a plurality of conductor stripes 98 are formed by a suitable metallization-depositing process on the surface 100 of the insulating board 34 (or 36), which is secured to a side of molybdenum supporting block 18. The conductor stripes 98 may be split tip welded to the conductors carried by ribbon cable 26; and the stripes 98 lead to the inner edge 102 of board 34 (or 36) nearest the silicon chips. In order to permit "T-shaped" electrical junctions to be formed at the ends of stripes 98, the insulating strip 38 is secured to board 34 (or 36), and provides an edge 104 adjoining edge 102 on the board. A plurality of conductor stripes 106 are formed by a suitable metallization-depositing process on the plane formed by the adjoining edges 104 and 102. The stripes 106 lead to the outer edge 108 of the insulating strip 38.

The remaining step required to complete the lead-out connections is to join the respective conductor stripes 94 (on the back plane) with the stripes 106, by means of a T-shaped connection. Insulating board 32 is placed between the back plane of the stacked chips and the supporting block assembly; and those structures are glued together. Then conductor stripes 110 are formed by a suitable metallization-depositing process on the plane formed by the outer surface 112 of the module of stacked chips, the outer surface 114 of strip 38, and the outer edge 116 of insulating board 32.

Each of the three metallization-depositing steps is preceded by etching, passivation, and lapping, of the planar surfaces, and results in a T-shaped electrical contact, in that the conductor stripes deposited on the planar surfaces extend beyond the intersecting ends of the leads appearing on those surfaces.

The remaining figures outline the complete step-by-step process which is the presently preferred method of fabricating the module 12 containing the stacked silicon chips.

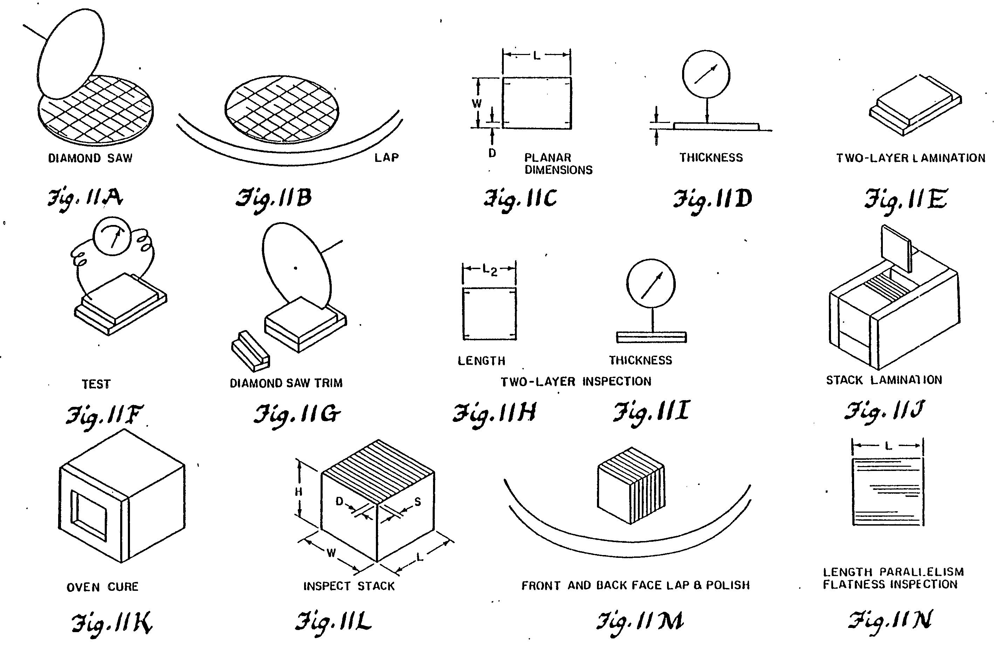

Figures 11A through 11N carry the process for the initial silicon wafers to the completed stack of silicon chips. Figures 11A and 11B illustrate the steps used to dice the silicon wafers to form the individual integrated circuit chips 14. The wafers have a nominal thickness of .01 inch (0.254 mm). As shown in Figure 11A, the first step is to use a diamond saw to cut intersecting grooves into the circuit-carrying surface of the wafer to a depth slightly more than the final chip thickness. Then, as illustrated in Figure 11B, the other side of the wafer is lapped until the final thickness is achieved. In practice, the grooved wafer is placed face down on a lapping flat covered with an adhesive material which retains the pieces of the wafer in position after the lapping reaches the grooves, thereby dividing the wafer into small rectangular chips. The next step, which is not illustrated, is depositing passivation on the undersides of the chips. Then, as shown in Figures 11C and 11D, the planar dimensions and thickness of each chip are checked. The planar dimensions, including length, width, and signal lead edge distance, may be checked using a toolmaker's microscope capable of measuring to an accuracy of +/− .00005 inch (± 0.00127 mm). The thickness may be measured using a digital height gauge capable of measuring to an accuracy of +/− .0005 inch (± 0.0127 mm).

Figures 11E through 11I show a two-layer amination procedure, which is the presently preferred method, because the two-layer combinations permit convenient electrical testing, and also provide structure reinforcement not available when single chips are being handled. As shown in Figures 11E and 11F, the two layers secured together may initially have different lengths, in order to simplify testing. Then, as seen in Figure 11G, a diamond saw is used to trim both chips to the desired dimensions, which are carefully checked, as indicated in Figures 11H and 11I, using a toolmaker's microscope. The bonding of the two layers may be accomplished in a special fixture. Alignment of conductor ends on the two layers must be within +/− .0002 inch (± 0.00508 mm). The next step, as illustrated in Figure 11J, is lamination of the complete stack of silicon chips, combining enough two-stack layers to provide the selected number of layers. The stacking fixture and alignment process must ensure alignment of conductor ends within +/− .0002 inch (± 0.00508 mm). As indicated in Figure 11K, an oven cure is next used to set the epoxy which bonds the layers. After another inspection (Figure 11L), the front (focal plane), and back faces of the stacked chip module are lapped and polished (Figure 11M). Another inspection is indicated by Figure 11N.

Figures 12A to 12E illustrate the important series of steps needed to provide metallization on the front and back faces of the module. First, as shown in Figures 12A both the front and back surfaces of the module are separately etched to remove the silicon to a depth of about .0005 inch (0.0127 mm), as previously discussed. During the separate etching of the front and back surfaces, the other four faces of the cube should all be protected from the etching by passivation.

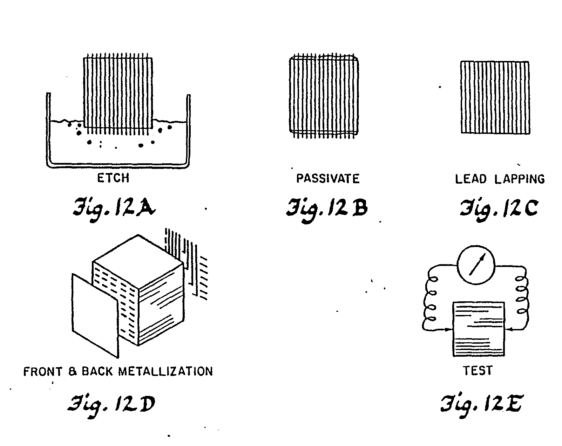

Next, passivation is applied to both the front and back surfaces, as shown in Figure 12B. Then the front and back surfaces are lapped to uncover the leads (Figure 12C). And thereafter, metallization is applied separately to both the front and back surfaces by a thin film deposition process (Figure 12D). The metallized pattern on the back surface provides the desired conductor stripes, as previously described. On the front surface, a complete layer of metallization is shown. This is the approach which is used if the detector "islands" are going to be isolated by cutting channels in a detector material wafer, after such a wafer has been bonded to the face of the module.

During the channel cutting process used to isolate the detectors (such as ion milling, discussed in US—A—4 290 844), the metallized layer shown in Figure 12D will also be cut through, thus forming the isolated "islands" corresponding to the respective detectors. If the passivation on the front surface of the module is also cut through during this process, no harm is done because each detector remains electrically isolated except for its individual conductor lead (and the common electrode formed on the top side of the detector islands). Figure 12E illustrates an electrical signal testing step, which is next performed.

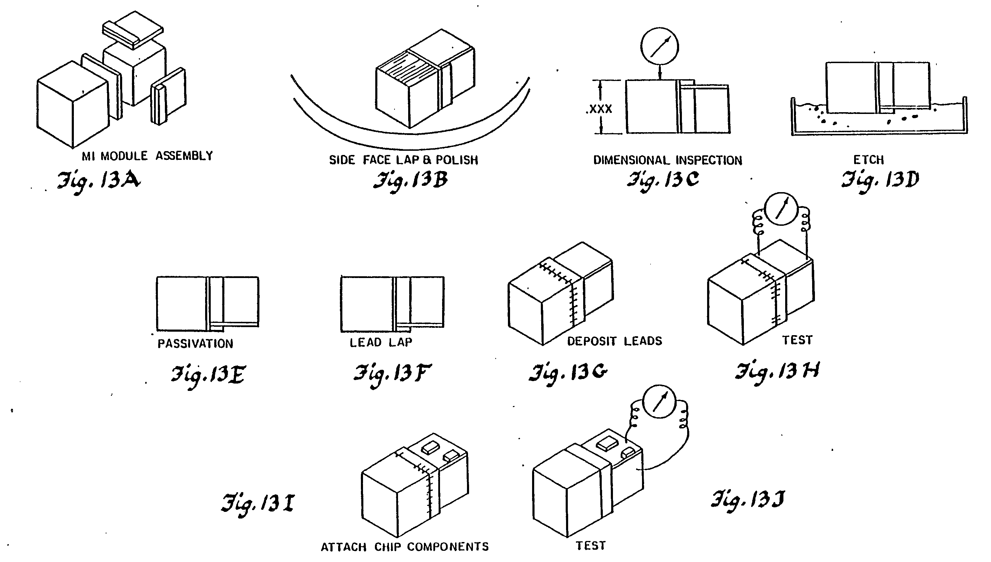

Figures 13A to 13J show the assembling and processing of the complete module, including mounting of the silicon stack on the molybdenum supporting block, and depositing conductors which lead out of the back plane to exterior circuitry. As shown in Figure 13A, the parts of the complete module are place together, carefully aligned, and bonded. The parts are the silicon stack 12, the molybdenum supporting block 18, and the insulating boards 32, 34 and 36.

Then each of the two side faces of the module on which conductor stripes are to be deposited will be separately taken through the same process steps as those used in providing electrical connections on the front and back surfaces of the stacked chips. Each of the two sides faces will be lapped and polished (Figure 13B), inspected (Figure 13C), etched to cut back the silicon slightly, covered with passivation (Figure 13E), and lapped to uncover the leads (Figure 13F). Then the final T-shaped leads will be formed, as shown in Figure 13G, by depositing short conductor stripes on the surface to interconnect the stripes on the back surface of the silicon stack with those on the front end of the insulating boards 34 and 36. Those boards have already been provided with the T-shaped connections leading to the ribbon cables. Figures 13H to 13J show an electrical testing step, then attaching additional chips on one insulating board surface, and finally, another electrical testing step.

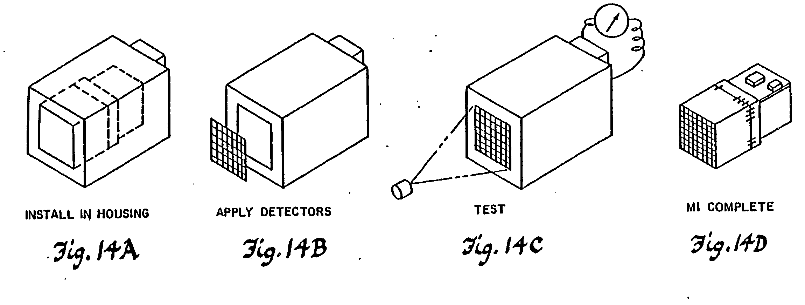

Figures 14A to 14D refer to the final steps in completing the functioning focal plane module, i.e., placing photo-detectors on the face of the module, each in individual electrical contact with a singe lead appearing at the face of the module. The presently preferred method of forming the individual detectors is that disclosed in US—A—4 290 877, that is, in brief, by the steps of (a) depositing a metallic layer on the insulation-covered focal plane and, (b) bonding photodetector material to the metallic layer with conductive bonding material, and (c) dividing the photoconductive material and the underlying conductive material into islands which provide individual photodetectors. However, other methods of placing or forming individual photo-detectors on the face of the module could be used without departing from the scope of the present invention. Such alternative methods include indium bump bonding, or thin film.

Figure 14A shows the module installed in a protective housing, on the assumption that it would be sent to another facility for detector emplacement. The remaining Figures (14B to 14D) briefly list the detector application process (which is itself a complex series of steps), and subsequent final testing, leading to completion of the module. The module is then ready to be installed with other modules in a four-module group, as seen in Figure 3; and a large number of those groups are installed in a complete focal plane assembly, such as the one illustrated in Figure 4.

## Claims

1. A photo detector array module (12), one end of which terminates in a focal plane (16) and the other end of which terminates in a back plane, the focal plane end of the module (12) having a multiplicity of closely spaced electrical points (80) thereon, to which a corresponding multiplicity of photo-detectors (69) is connected and the back plane end of the module (12) also having a multiplicity of electrical contact points thereon; characterised in that:

said module (12) comprises a plurality of signal processing semiconductor chips (14) of substantially identical dimensions stacked and secured together to form a multiple layer structure, one end of which defines said focal plane (16) and the other end of which defines said back plane, the semiconductor chips (14) extending in layers perpendicular to the focal plane (16) and back plane; and in that:

said multiplicity of closely spaced electrical contact points (80) on the focal plane end of the module (12) are provided by the ends of metal leads (68) formed as part of the integrated circuitry on the chip (14), the electrical contact points (80) of the focal plane end of each semiconductor chip (14) having a predetermined, substantially exact spatial relationship with the electrical contact points (80) on the focal plane ends of the other stacked semiconductor chips (14); and further characterised by:

insulation (74) covering the entire focal plane end of the stacked chips (14) except for the contact points (80) thereon, and preventing current leakage between the contact points (80) and the focal plane ends of the substrates (14); and

insulation covering the back plane end of the stacked chips (14) except for the contact points thereon, and preventing current leakage between the contact points and the back plane ends of the substrates (10).

2. The photo-detector array module of claim 1 which also includes:

a plurality of electrical conductors (94) formed as stripes on the back plane of the stack of semiconductor chips, each such conductor stripe interconnecting the contact points on a plurality of chips (14) and providing electrical connections to external wiring (26).

3. The photo-detector array module of claim 1 or claim 2, which also includes:

a multiplicity of photo-detectors (69) formed independently of the semiconductor chips (14) and bonded to the focal plane end of the stacked chips (14), with each photo-detector (69) in individual electrical contact with a single electrical contact point (68) on the focal plane (16).

4. The photo-detector array module of claim 2 wherein the electrical conductor stripes (94) formed on the back plane extend on both sides of each intersecting contact point (92) to provide a T-shaped joint of continuous conductive material.

5. A method for fabricating a photo-detector array module (12) comprising forming a module structure incorporating electronic components and defining a focal plane, and mounting a mutiplicity of photo-detectors on said focal plane in electrical connection with said electronic components; characterised by:

providing a number of equal-sized semiconductor chips (14), each having integrated circuitry thereon, and each having a multiplicity of closely spaced electrical contact points (80 or 92) at one end thereof;

stacking and bonding the semiconductor chips (14) to form a rectangular parallelepiped structure with the electrical contact points (80 to 92) in an array of closely spaced points on one end of the stacked chips (14) defining said focal plane (16);

etching said ends of the stacked chips (14) to remove a small amount of the body material of the chips while leaving the contact points (80 or 92) protruding;

depositing insulation material (74) to cover the etched ends of the stacked chips (14);

removing sufficient material from the insulation-covered ends of the stacked chips to uncover the electrical contact points (80 or 92); and

placing a multiplicity of photo-detectors (69) on the insulation-covered ends of the stacked chips (14) in such a way that each photo-detector (69) is in electrical contact with a single electrical contact point (80 or 92), while being otherwise insulated from the body material of the semiconductor chips (14).

6. The method of claim 5 wherein the step of placing photo-detectors (69) on the stacked chips includes:

depositing a metallic layer on the insulation-covered focal plane ends of the stacked chips;

bonding photo-detector material to the metallic layer with conductive bonding material; and

dividing the photo-detector material and the underlying conductive material into islands which provide individual photo-detectors.

7. The method of claim 5 or claim 6 wherein the step of etching the ends of the stacked chips includes:

etching back the material used to bond the stack of chips together; and

then etching the ends of the stacked chips to remove a small amount of the body material.

8. The method of any of Claims 5 to 7 wherein each chip (14) in the stack is separated from the adjacent chips by insulating material (64, 66, 70) overlying the integrated circuitry, and the electrical contact points (80 or 92) are partially supported by such material during the steps of first etching, and then depositing insulation material on, said ends of the stack, thereby preventing the protruding contact points (80 or 92) from making electrical contact with the chip substrates.

9. The method of any of claims 5 to 8 wherein the step of etching the ends of the stacked chips (14) is accomplished by a dry process using a gas plasma.

10. The method of claim 5, in which said ends of the stacked chips (14) form a back plane; and including th steps of:

forming thin film conductors (94) on the back plane to make contact with appropriate electrical contact points (92) thereon, each conductor (94) extending across the end of its contact points (92) to provide a T-shaped junction; and

providing electrical connections leading from the conductors (94) on the back plane to exterior circuitry.

11. The method of claim 10 wherein the step of providing electrical connections to external circuitry includes:

forming T-shaped thin film junctions (98, 106) over the ends of the conductors (94) on the back plane to provide electrical connections extending perpendicular to the back plane.

## Patentansprüche

1. Modul (12) mit Photodetektoranordnung, dessen eines Ende in einer Fokusebene (16) und dessen anderes Ende in einer Rückebene endet, wobei an dem die Fokusebene bildenden Ende des Moduls (12) eine Vielzahl eng beabstandeter elektrischer Punkte (80) angeordnet ist, mit denen entsprechend viele Photodetektoren (69) verbunden sind, und wobei auch an dem die Rückebene bildenden Ende des Moduls (12) mehrere elektrische Kontaktpunkte angeordnet sind; dadurch gekennzeichent, daß

das Modul (12) mehrere Signalverarbeitungs-Halbleiterchips (14) mit im wesentlichen identischen Abmesseungen aufweist, die so gestapelt und miteinander befestigt sind, daß sie eine Mehrschichten-struktur bilden, deren eines Ende die Fokusebene (16) und deren anderes Ende die Rückebene bildet, wobei die Halbleiterchips (14) in rechtwinklig zur Fokusebene (16) und zur Rückebene angeordneten Schichten verlaufen; und dadurch, daß

die Vielzahl eng beabstandeter elektrischer Kontaktpunkte (80) an dem die Fokusebene bildenden Ende des Moduls (12) aus den Enden von Metallanschlüssen (68) bestehen, die als Teil der integrierten Schaltung auf dem Chip (14) ausgebildet sind, wobei die elektrischen Kontaktpunkte (80) des dies Fokusebene bildenden Endes jedes Halbleiterchips (14) eine vorbestimmte, im wesentlichen exakte räumliche Beziehung zu den elektrischen Kontaktpunkten (80) an den die Fokusebene bildenden Enden der anderen gestapelten Halbleiterchips (14) einnehmen; und ferner gekennzeichnet durch:

eine Isolierung (74), die das gesamte die Fokusebene bildende Ende dr gestapelten Chips (14) mit Ausnahme der auf diesen befindlichen Kontaktpunkte (80) bedeckt und Leckströme zwischen de Kontaktpunkten (80) und den die Fokusebene bildenden Enden der Chips (14) verhindert; und

eine Isolierung, die das die Rückebene bildende Ende der gestapelten Chips (14) mit Ausnahme der auf diesen befindlichen Kontaktpunkte bedeckte und Stromverlust zwischen den Kontaktpunkte und den die Rückebene bildenden Enden der Chips (14) verhindert.

2. Modul mit Photodetektoranordnung nach Anspruch 1, ferner versehen mit:

mehreren elektrischen Leitern (94), die als Streifen auf der Rückebene des Halbleiterchip-Stapels ausgebildet sind, wobei jeder Leiterstreifen die an mehreren Chips (14) befindlichen Kontaktpunkte miteinander verbindet und elektrische Verbindungen zu externer Verdrahtung (26) schafft.

3. Modul mit Photodetektoranordnung nach Anspruch 1 oder 2, ferner versehen mit:

mehreren Photodetektoren (69), die unabhängig von den Halbleiterchips (14) ausgebildet und mit dem die Fokusebene bildenden Ende der gestapelten Chips (14) verbondet sind, wobei sich jeder Photodetektor (69) in individuellem elektrischen Kontakt mit einem einzelnen elektrischen Kontaktpunkt (68) auf der Fokuebene (16) befindet.

4. Modul mit Photodetektoranordnung nach Anspruch 2, bei dem die auf der auf der Rückebene ausgebildeten elektrischen Leiterstreifen (94) so zu beiden Seiten jedes kreuzenden Kontaktpunktes (92) verlaufen, daß sie eine T-förmige Verbindung aus kontinuierlich leitendem Material bilden.

5. Verfahren zur Herstellung eines Moduls (12) mit Photodetektoranordnung, bei dem eine Modul-Struktur geschaffen wird, die elektronische Komponenten enthält und eine Fokusebene bildet, und auf der Fokusebene eine Vielzahl von Photodetektoren in elektrischer Verbindung mit den elektronischen Komponenten montiert wird; gekennzeichnet durch:

Schaffen einer Anzahl gleich bemessener Halbleiterchips (14), auf denen jeweils eine integrierte Schaltung angeordnet ist und die jeweils an einem ihrer Enden eine Vielzahl eng beabstandeter elektrischer Kontaktpunkte (80 oder 92) aufweist;

Stapeln und Verbonden der Halbleiterchips (14) zu einer rechteckigen quaderartigen Struktur, wobei die elektrischen Kontaktpunkte (80 oder 92) als Anordnung eng beabstandeter Punkte an einem Ende der die Fokusebene (16) bildenden gestapelten Chips (14) angeordnet sind;

Ätzen der Enden der gestapelten Chips (14) zum Entfernen einer geringen Menge des Körpermaterials der Chips, wobei die Kontaktpunkte (80 oder 92) im vorrangenden Zustand belassen werden;

Auftragen von Isoliermaterial (74) zum Bedecken der geätzten Enden der gestapelten Chips (14);

Entfernen einer hinreichenden Materialmenge von den mit Isolierung bedeckten Enden der gestapelten Chips, um die elektrischen Kontaktpunkte (80 oder 92) freizulegen; und

Plazieren einer Vielzahl von Photodetektoren (69) auf den mit Isolierung bedeckten Enden der gestapelten Chips (14), derart, daß sich jeder Photodetektor (69) in elektrischem Kontakt mit einem einzelnen elektrischen Kontaktpunkt (80 oder 92) befindet, während er im übrigen von dem Körpermaterial des Halbleiterchips (14) isoliert ist.

6. Verfahren nach Anspruch 5, bei dem der Schritt des Plazierens von Photodetektoren (69) auf den gestapelten Chips einschileßt:

Auftragen einer Metallschicht auf die von Isolierung bedeckten, die Fokusebene bildenden Enden der gestapelten Chips;

Verbonden von Photodetektormaterial mit der Metallschicht mit leitendem Bondmaterial; und

Aufteilen des Photodetektormaterials und des unterliegenden leitenden Materials in Inseln, welche einzelne Photodetektoren bilden.

7. Verfahren nach Anspruch 5 oder 6, bei dem der Schritt des Ätzens der Enden der gestapelten Chips einschließt:

Zurückätzen des zum Zusammenbonden des Chip-Stapels verwendeten Materials; und

anschließend Ätzen der Enden der gestapelten Chips zum Entfernen einer geringen Menge des Körpermaterials.

8. Verfahren nach einem der Ansprüche 5 bis 7; bei dem jeder Chips (14) in dem Stapel von den benachbarten Chips durch Isoliermaterial (64, 66, 70) getrennt wird, welches der integrierten Schaltung überliegt, und die elektrischen Kontaktpunkte (80 oder 92) während der Schritte des ersten Ätzvorgangs teilweise von diesem Material getragen werden, und anschließend Auftragen von Isoliermaterial auf die Enden des Stapels, so, daß verhindert wird, daß die vorragenden Kontaktpunkte (80 oder 92) in elektrischen Kontakt mit den Chip-Substraten gelangen.

9. Verfahren nach einem der Ansprüche 5 bis 8, bei dem der Schritt des Ätzens der Enden der gestapelten Chips (14) durch ein Trockenverfahren unter Verwendung eines Gasplasmas erfolgt.

10. Verfahren nach Anspruch 5, bei dem die Enden der gestapelten Chips (14) eine Rückebene bilden, und das die folgenden Schritte aufweist:

Bilden von Dünnfilmleitern (94) auf der Rückebene, so, daß diese in Kontakt mit passenden elektrischen Kontaktpunkten (92) auf der Rückebene gelangen, wobei jeder Leiter (94) so über das Ende seiner Kontaktpunkte (92) verläuft, daß eine T-förmige Verbindung geschaffen wird; und

Schaffen elektrischer Verbindungen, die von den Leitern (94) auf der Rückebene zu einer externen Schaltung führen.

11. Verfahren nach Anspruch 10, bei dem der Schritt des Schaffens elektrischer Verbindungen zu einer externen Schaltung einschließt:

Bilden T-förmiger Dünnfilmverbindungen (98, 106) über die Enden der Leiter (94) an der Rückebene, so, daß elektrische Verbindungen geschaffen werden, die rechtwinklig zur Rückebene verlaufen.

**Revendications**

1. Module de réseau photo-détecteur (12), dont

une extrêmité se termine en un plan focal (16) et dont l'autre extrémité se termine en un plan arrière, l'extrèmité de plan focal du module (12) portant une pluralitè de points électriques (80) rapprochés entre eux, auxquels est reliée une pluralité correspondante de photo-détecteurs (69), et l'extrèmité de plan arrière du module (12) portant également une pluralité de points de contact électrique, caractérisé en ce que:

ledit module (12) comprend une pluralitè de pastilles de semiconducteur de traitement de signal (14) de dimensions essentiellement identiques, empilées et assemblées entre elles de manière à former une structure multicouches, dont une extrémité définit ledit plan focal (16) et dont l'autre extrémité définit ledit plan arrière, la pastille de semiconducteur (14) s'étendant en couches perpendiculaires au plan focal (16) et au plan arrière; et en ce que:

ladite pluralité de points de contact électrique rapprochés (80), à l'extrémité de plan focal du module (12), est prévue aux extrémités de sorties métalliques (68) formées en faisant partie du circuit intégré sur la pastille (14), les points de contact électrique (80) de l'extrêmité de plan focal de chaque pastille de semiconducteur (14) ayant une relation spatiale prédéterminée, essentiellement précise, avec les points de contact électrique (80) sur les extrémités de plan focal des autres pastilles de semiconducteur empilées (14); et caractérisé en outre par:

un élément isolant (74) recouvrant toute l'extrêmité de plan focal des pastilles de semiconducteur empilées (14), sauf les points de contact électrique (80) disposés dessus, et evitant la fuite de courant entre les points de contact électrique (80) et les extrêmités de plan focal des substrats (14); et

un élément isolant recouvrant l'extrêmité de plan arrière des pastilles empilées (14), sauf les points de contacts disposés dessus, et évitant les fuites de courant entre les points de contact et les extrémités de plan arrière des substrats (10).

2. Module de réseau photo-détecteur selon la revendication 1, comprenant également:

une pluralité de conducteurs électriques (94) sous forme de bandes sur le plan arrière de la pile de pastilles de semiconducteur, chaque bande de conducteur de ce type interconnectant les points de contact sur une pluralité de pastilles (14) et fournissant des connexions électriques pour le câblage extérieur (26).

3. Module de réseau photo-détecteur selon la revendication 1 ou 2, comprenant également:

une pluralité de photo-détecteurs (69) formés indépendamment des pastilles de semiconducteur (14) et liés à l'extrêmité de plan focal des pastilles empilèes (14), chaque photo-détecteur (69) étant en contact électrique individuel avec un point de contact électrique unique (68) du plan focal (16).

4. Module de réseau photo-détecteur selon la revendication 2, dans lequel les bandes conductrices électriques (94), formées sur le plan arrière, s'étendent de part et d'autre de chaque point de contact d'intersection (92) pour produire un joint en forme de T en matériau conducteur continu.

5. Procédé de fabrication d'un module de réseau photo-détecteur (12) comprenant la formation d'une structure de module à laquelle sont incorporés des composants électroniques et définissant un plan focal, et le montage d'une pluralité de photo-détecteurs sur ledit plan focal en connexion électrique avec ledits composants électroniques; caractérisé par les étapes consistant à:

prévoir un certain nombre de pastilles de semiconducteur (14) de dimensions égales, portant chacune un circuit intégré, et ayant chacune une pluralité de points de contact électrique rapprochés (80 ou 92) à une de ses extrémités;

empiler et lier les pastiles de semiconducteur (14) de façon à former une structure parallèlepipèdique rectangulaire avec les points de contact électrique (80 ou 92) en un réseau de points rapprochés sur une extrémité des pastilles empilées (14) définissant ledit plan focal (16);

graver lesdites extrémités des pastilles empilées (14) pour enlever une faible quantité de matériau du corps des pastilles, en laissant ainsi les points de contact (80 ou 92) en saillie;

déposer un matériau isolant (74) pour recouvrir les extrémités gravées des pastilles empilées (14);

enlever suffisamment de matériau des extrêmitès recouvertes par le matériau isolant des pastilles empilées pour découvrir les points de contact électrique (80 ou 92); et

placer une pluralité de photo-détecteurs (69) sur les extrêmités couvertes par du matériau isolant des pastilles empilées (14) de telle façon que chaqque photo-détecteur (69) soit en contact électrique avec un seul point de contact (80 ou 92), en étant par ailleurs isolé du matériau du corps des pastilles de semi-conducteur (14).

6. Procédé selon la revendication 5, dans lequel l'étape de mise en place de photo-détecteurs (69) sur les pastilles empilées consiste à:

déposer une couche métallique sur les extrêmités de plan focal recouvertes de matériau isolant des pastilles empilées;

lier le matériau photo-détecteur à la couche métallique par un matériau liant conducteur; et

diviser le matériau photo-détecteur et le matériau conducteur sous-jacent en îlots constituant des photo-détecteurs individuels.

7. Procédé selon la revendication 5 ou 6, dans lequel l'étape de gravure des extrémités des pastilles empilées consiste à:

regraver le matériau utilisé pour lier la pile de pastilles; et

ensuite, graver les extrémités des pastilles empilées pour enlever une faible quantité de matériau du corps.

8. Procédé selon l'une quelconque des revendications 5 à 7, dans lequel chaque pastille (14) de la pile est séparée des pastilles adjacentes par un matériau isolant (64, 66, 70) recouvrant le circuit intégré, et les points de contact électrique (80 ou 92) sont en partie portés par ce matériau pendant les étapes de première gravure, et ensuite, il est déposeé un matériau isolant sur lesdites extrêmités de la pile, évitant ainsi qu'un contact électrique ne s'établisse entre les points de contact en saillie (80 ou 92) et les pastilles de substrat.

9. Procédé selon l'une quelconque des revendications 5 à 8, dans lequel l'étape de gravure des extrêmités des pastilles empilées (14) est effectuée par un procédé sec au gaz plasma.

10. Procédé selon la revendication 5, dans lequel lesdites extrêmités des pastilles empilées (14) forment un plan arrière; et constitué par les étapes consistant à:

former des conducteurs de film mince (94) sur le plan arrière pour établir un contact avec des points de contact électrique appropriés.(92), chaque conducteur (94) s'étendant à travers l'extrémité de ses points de contact (92) pour produire une jonction en forme de T; et

produire des connexions électriques reliant des conducteurs électriques (94) sur le plan arrière au circuit extérieur.

11. Procédé selon la revendication 10, dans lequel l'étape de formation de connexions électriques pour le circuit extérieur consiste à:

former des jonctions de film mince en forme de T (98, 106) sur les extrêmités des conducteurs (94) sur le plan arrière, pour produire des connexions électriques s'étendant perpendiculairement au plan arrière.

Fig.1

Fig. 2

Fig. 3

*Fig. 4*

*44* ON FOCAL PLANE UNIFORMITY COMPEN-SATION

*46* ACTIVE BANDPASS FILTER (MOVEABLE POLES) 12 dB/OCTAVE CUT-ON AND CUT-OFF 128 IN – 128 OUT

*48* MOS AMP/MUX 1024 TO I

*50* SIGNAL PRE-PROCESSING ELECTRONICS

*52* 32 TO I MUX

*54* 13 BIT ADC

HIGH LEVEL PROCESSING

CLOCKS

*56* CLOCK & LOW NOISE BIAS GENERATOR

SUPPLY AND LOW NOISE BIAS VOLTAGES

ON FOCAL PLANE

TYPICAL OFF-FOCAL PLANE PROCESSING

*Fig. 5*

Fig.6A   Fig.6B   Fig.6C   Fig.6D

Fig. 7A

Fig. 7B

90

82

86

88

68

69

*Fig. 8*

Fig. 9

Fig. 10

DIAMOND SAW

*Fig. 11A*

LAP

*Fig. 11B*

L

W

D

PLANAR DIMENSIONS

*Fig. 11C*

THICKNESS

*Fig. 11D*

TWO-LAYER LAMINATION

*Fig. 11E*

TEST

*Fig. 11F*

DIAMOND SAW TRIM

*Fig. 11G*

$L_2$

LENGTH

THICKNESS

TWO-LAYER INSPECTION

*Fig. 11H*

*Fig. 11I*

STACK LAMINATION

*Fig. 11J*

OVEN CURE

*Fig. 11K*

H

D

S

W

L

INSPECT STACK

*Fig. 11L*

FRONT AND BACK FACE LAP & POLISH

*Fig. 11M*

L

LENGTH PARALLELISM FLATNESS INSPECTION

*Fig. 11N*

EP 0 161 246 B1

ETCH

*Fig. 12A*

PASSIVATE

*Fig. 12B*

LEAD LAPPING

*Fig. 12C*

FRONT & BACK METALLIZATION

*Fig. 12D*

TEST

*Fig. 12E*

MI MODULE ASSEMBLY

*Fig. 13A*

SIDE FACE LAP & POLISH

*Fig. 13B*

DIMENSIONAL INSPECTION

*Fig. 13C*

ETCH

*Fig. 13D*

PASSIVATION

*Fig. 13E*

LEAD LAP

*Fig. 13F*

DEPOSIT LEADS

*Fig. 13G*

TEST

*Fig. 13H*

*Fig. 13I*

ATTACH CHIP COMPONENTS

TEST

*Fig. 13J*

Fig.14A INSTALL IN HOUSING

Fig.14B APPLY DETECTORS

Fig.14C TEST

Fig.14D MI COMPLETE